# EUROPEAN PATENT APPLICATION

(11) **EP 4 679 211 A1**
(43) Date of publication of application: **14.01.2026**
(21) Application number: 25187313.9
(22) Date of filing: 03.07.2025
(51) Int. Cl.: G05B 19/418

(54) **DEVICE FOR CONSTRUCTING A PRODUCTION LINE, METHOD FOR CONSTRUCTING A PRODUCTION LINE, AND PROGRAM**

(30) Priority: 09.07.2024 JP 2024110459
(71) Applicant: Yokogawa Electric Corporation, Tokyo 180-8750 (JP)
(72) Inventor: KONISHI, Takumi, Musashino-shi, Tokyo, 180-8750, (JP)
(74) Representative: Winter, Brandl - Partnerschaft mbB

(57) **Abstract**

A device (A) for constructing a production line includes: an acquisition unit (14) configured to acquire construction information (15) including definition information (32) defining a function, performance, and interface requirements of a module (M) in a modular plant, and physical information (33) including physical characteristics of the module (M) and information on a carry-in destination of the module (M); and a generation unit (14) configured to generate, based on the acquired construction information (15), a configuration and an arrangement plan of the module (M).

## Description

### BACKGROUND OF THE INVENTION

### 1. Field of the Invention

The present disclosure relates to a device for constructing a production line, a method for constructing a production line, and a program.

### 2. Description of the Related Art

In conventional plant designs, it is common that respective portions of a process are custom-designed and constructed as an integrated system. For this reason, design, construction, and expansion of a plant require time and cost.

Among conventional plant designs, a production line construction system in a modular plant constructs a production line by combining a plurality of independent modules. This production line construction system uses a modular type package (MTP) technology to increase flexibility and efficiency of a manufacturing process.

The MTP technology is a technology for supporting the design and operation of a modular plant. The MTP technology provides an MTP file including MTP information that defines functions, performance, and interface requirements of specific process modules. By using such MTP information, it is possible to integrate modules from different manufacturers and to design a configuration and an arrangement plan of a module that can easily change the configuration of the entire plant.

In the conventional MTP technology, a process module is defined at a logical level, and a function and a process control requirement of the process module are designated. The process modules with designated functions and requirements are selected during the design phase of the plant. The selected process modules are then combined to form an overall process flow.
Patent Literature 1: JP H06-348769 A
Patent Literature 2: JP 2012-014309 A

### SUMMARY OF THE INVENTION

However, in the conventional MTP technology, physical arrangement of modules and interaction in an actual plant are secondary considerations, and mainly focus on logical cooperation and optimization of a process flow to form an overall process flow.

Therefore, it is not possible to determine that a production line of the logically constructed configuration and arrangement plan of a module can be suitable for a physical section of an actual plant. Being suitable for the physical section of the actual plant means, for example, that there is a space for carrying in a device, that there is a conductive wire for carrying in and out the device, and the like.

The present disclosure has been made in view of the above-described circumstances, and provides a device for constructing a production line, a method for constructing a production line, and a program capable of generating a modular plant that can be physically carried in to a carry-in destination.

According to an aspect of an embodiment, a device for constructing a production line includes an acquisition unit configured to acquire construction information for a production line including definition information and physical information, the definition information defining a function, performance, and interface requirements of a module in a modular plant, the physical information including physical characteristics of the module and information on a carry-in destination of the module, and a generation unit configured to generate, based on the acquired construction information, a configuration and an arrangement plan of the module.

### BRIEF DESCRIPTION OF THE DRAWINGS

FIG. 1 is a diagram for describing a production line construction system in a modular plant according to an embodiment;
FIG. 2 is a diagram illustrating a configuration of a production line construction system in the modular plant according to the embodiment;
FIG. 3 is a diagram illustrating information stored in a plant design DB;
FIG. 4 is a diagram illustrating a first example of a relationship between a constraint condition, an objective function, and an output;
FIG. 5 is a diagram illustrating a second example of the relationship between the constraint condition, the objective function, and the output;
FIG. 6 is a diagram illustrating data transfer among an engineering tool unit, a line construction engine unit, and the plant design DB;
FIG. 7 is a flowchart for describing the operation of the production line construction system in the modular plant according to the embodiment;
FIG. 8 is a diagram illustrating an example of a screen for inputting condition information of the production line construction system in the modular plant according to the embodiment;
FIG. 9 is a diagram illustrating an example of a configuration and an arrangement plan of a module in the case of minimizing energy efficiency of the production line construction system in the modular plant according to the embodiment;
FIG. 10 is a diagram illustrating an example of a configuration and an arrangement plan of a module in the case of maximizing production efficiency of the production line construction system in the modular plant according to the embodiment; and
FIG. 11 is a diagram for describing a hardware configuration example.

### DETAILED DESCRIPTION OF THE PREFERRED EMBODIMENTS

Hereinafter, preferred embodiments of the present disclosure will be described in detail with reference to the accompanying drawings. In the present specification and the drawings, components having substantially the same functional configuration will be denoted by the same reference numerals, and redundant descriptions will be omitted.

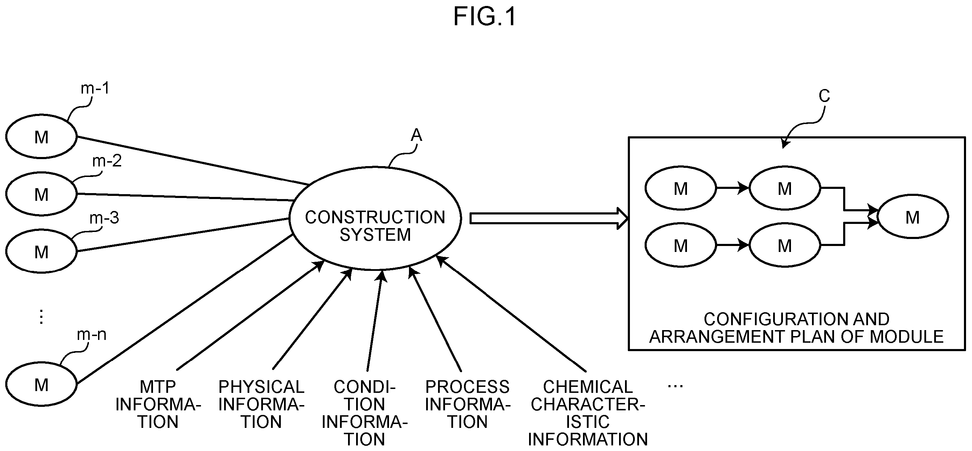

First, a construction system A for a production line in a modular plant of the present disclosure will be described. FIG. 1 is a diagram for describing the construction system A in the modular plant according to the embodiment. The construction system A illustrated in FIG. 1 is an example of a device for constructing a production line or a computer that generates a plant of a physical size capable of being carried into a carry-in destination by logically and physically combining the modular plants.

Here, plant construction using a modular plant and problems thereof will be described.

### 1. Lack of Physical Information and Chemical Characteristics

An MTP file does not include detailed process information such as physical dimensions and chemical characteristics of a module and the maximum carry-out capacity. This makes it difficult to determine whether a designed production line is suitable for an actual plant space, whether there is enough space to arrange a device, whether necessary wiring or pipelines can be installed, and the like.

### 2. Insufficient Consideration of Rearrangement

In the conventional MTP technology and plant design, emphasis is put on determining an optimum arrangement when a module is newly installed, but rearrangement and expansion of a module in an existing plant are not sufficiently considered. This is a major problem for modem manufacturing industries that need to respond quickly to market demand fluctuations and process updates.

### 3. Reason for Adoption of Mechanism/Circuit

The reason for adopting the conventional MTP is to improve compatibility between process modules of different manufacturers and flexibility of a plant design. However, while achieving these objects, there are many restrictions in actual operation due to a lack of details related to physical arrangement and implementation in the plant.

Therefore, the construction system A according to the embodiment acquires construction information including MTP information defining the function, performance, and interface requirements of a module in a modular plant and physical information including physical characteristics of the module and information on a carry-in destination of the module. Then, the construction system A generates a configuration and an arrangement plan of a module based on the acquired construction information.

For example, as illustrated in FIG. 1, the construction system A outputs a configuration plan and an arrangement plan C of a module m suitable for conditions from among n modules m-1 to m-n based on MTP information of the module m, physical information including physical characteristics of the module and information on a carry-in destination, condition information, process information on the production line, chemical characteristic information, and the like.

As described above, the construction system A can execute a simulation or the like in consideration of the entrance, the space, or the like of a carry-in destination by using the physical information of the module and the like in addition to the MTP information, and thus, it is possible to generate a modular plant capable of being physically carried in to the carry-in destination.

### (1. Configuration)

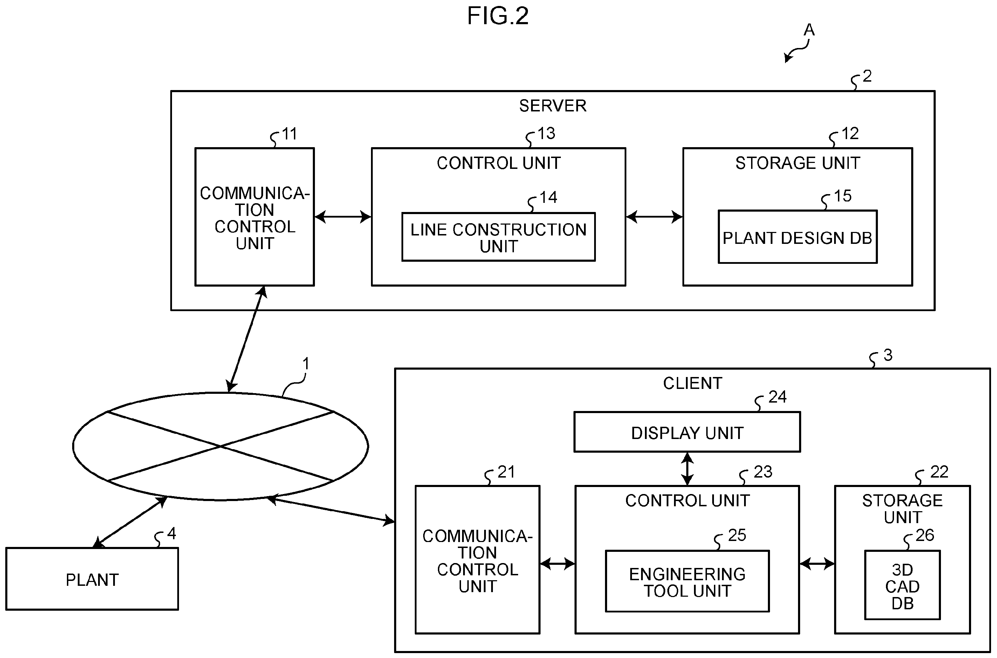

FIG. 2 is a diagram illustrating a configuration of the construction system A in the modular plant according to the embodiment. As illustrated in FIG. 2, the construction system A includes a server 2 that constructs a production line of a plant 4 connected to a network 1, and a client 3 that displays the production line generated in the server 2.

It is noted that, although FIG. 2 illustrates the construction system A in the case of a server client system, the construction system A may be a device for constructing a production line that is a single information processing device. In this case, the control unit of the information processing device in the device for constructing a production line includes a line construction unit 14 and an engineering tool unit 25 described below. The storage unit of the information processing device includes a plant design DB 15 and a 3D CAD DB 26 described below. Furthermore, the information processing device includes a display unit 24 and a communication control unit 11, 21 described below. The device for constructing a production line of the present disclosure includes the construction system A of the server client system and the device for constructing a production line that is the single information processing device.

Furthermore, the server 2 may be used as software as a service (SaaS). In this case, the server 2 can apply a service of the present disclosure to a user of a plant other than the plant 4. Therefore, the construction system A of the present disclosure can construct a production line for the plant other than the plant 4.

### (1.1. Server 2)

The server 2 includes a communication control unit 11, a storage unit 12, and a control unit 13.

### (Communication Control Unit 11)

The communication control unit 11 controls communication with a device outside the server 2. For example, the communication control unit 11 outputs, to the client 3, a configuration and an arrangement plan of a module of a production line in a modular plant generated in the line construction unit 14 of the server 2. Furthermore, the communication control unit 11 receives condition information such as a production target transmitted from the client 3, and outputs the received condition information to the line construction unit 14 of the control unit 13.

### (Storage Unit 12)

The storage unit 12 is a functional unit that stores various pieces of data. As an example, the storage unit 12 is realized by an internal, external, or auxiliary storage of the server 2. The storage unit 12 stores the plant design DB 15 that stores module information.

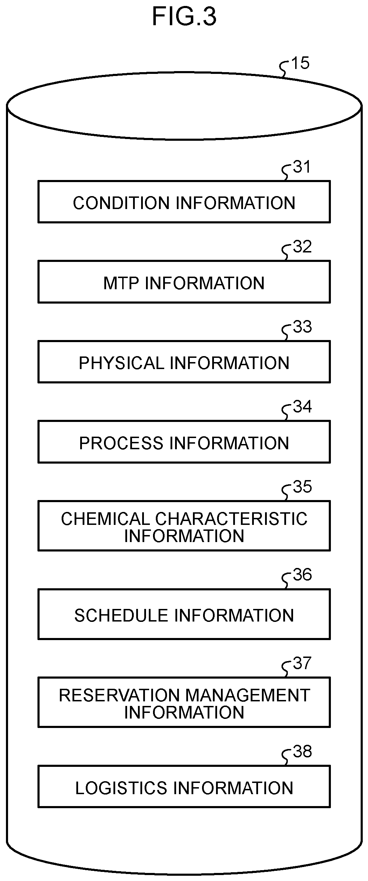

FIG. 3 is a diagram illustrating information stored in the plant design DB 15. The information stored in the plant design DB 15 includes information acquired from an external information source of the server 2 and information received from the client 3. As illustrated in FIG. 3, the plant design DB 15 is an integrated DB that stores condition information 31, MTP information 32, physical information 33, process information 34, chemical characteristic information 35, schedule information 36, reservation management information 37, and logistics information 38.

The plant design DB 15 also includes information related to compatibility and combinability between modules (not illustrated). By using such information, design flexibility of the module can be increased.

The condition information 31 is condition information at the time of generating the configuration and arrangement plan of the module of the modular plant. The condition information includes the fact that a logically constructed production line can be suitable for a physical section of an actual plant. Determination as to whether the logically constructed production line is suitable for the physical section of the actual plan includes, for example, determination as to whether there is a space for carrying in a suitable device in the physical section of the actual plant and whether there is a lead wire to be carried in and out.

The condition information 31 includes information corresponding to the above-described constraint condition and objective function. For example, the condition information 31 is information related to the constraint conditions including: 1. Modules can be carried in and disposed at a target location, 2. Consideration on constraints of a supply chain and logistics, 3. Management of availability and schedule of a unit, 4. Consideration on utilization efficiency of a physical space, 5. Economically reasonable, and 6. Consideration on whether chemical characteristics of a production unit are tolerable. In addition, for example, the condition information 31 is information related to the objective functions including: 1. Minimization of energy consumption, 2. Maximization of production efficiency and minimization of downtime, 3. Minimization of environmental burden in consideration of CO2 emissions, 4. Minimization of recombination work and saving of labor, 5. Minimization of cost required for line construction, and the like.

The condition information 31 includes information acquired from an external information source of the server 2 and information received from the client 3. In addition, the condition information may be stored in the plant design DB 15 in advance.

The MTP information 32 is information that defines functions, performance, and interface requirements of a module of a specific process.

The physical information 33 includes physical characteristics of the module and information on a carry-in destination of the module. The information on the carry-in destination of the module is, for example, the size of the floor at the carry-in destination of the module. The physical information may also include module throughput, capacity, resource and material efficiency, energy efficiency, power consumption, time to service provision, operation time, device availability, mean time between failures, service and device utilization.

The process information 34 is information indicating a process of the proposed configuration and arrangement plan of the module of the modular plant. The process information 34 may include information indicating the maximum carry-out capacity of the module. The chemical characteristic information 35 is information indicating the chemical characteristics of the module. The schedule information 36 is information indicating the production schedule of the module. The reservation management information 37 is information indicating a reservation status of the module. The logistics information 38 is information on a series of processes from procurement of a raw material to production of a product, sales to a final consumer, and collection and recycling after use.

### (Control Unit 13)

The control unit 13 is a functional unit that performs overall control of the server 2. For example, the control unit 13 can be realized by a hardware processor. The control unit 13 includes the line construction unit 14.

The line construction unit 14 generates a configuration and an arrangement plan of a module, a process flow plan, a production schedule plan of a product, and the like based on the construction information. Specifically, the construction information is the condition information 31, the MTP information 32 of the module, the physical information 33, the process information 34, the chemical characteristic information 35, the schedule information 36, the reservation management information 37, and the logistics information 38.

Here, the condition information 31 is information indicating conditions for generating the configuration and the arrangement plan of the modular plant. In addition, logistics is a strategic approach for achieving an optimal supply flow throughout management beyond a basic function of logistics that simply delivers goods to an appropriate place at an appropriate time. The logistics information 38 includes information on a series of processes from market procurement of a module, movement of a module between plants, procurement of a raw material, to production of a product, sales to a final consumer, and collection and recycling after use. Market procurement of the module is performed, for example, by purchasing the module at a shopping site. In the shopping site, a specification of a module is disclosed. In the shopping site, for example, specifications such as a carry-out capacity and a temperature characteristic of the module are disclosed. In addition, the physical information on the 3D CAD from the 3D CAD DB 26 of the client 3 is input to the line construction unit 14.

The line construction unit 14 is an AI model or a simulator that outputs a configuration and an arrangement plan of a module, a process flow plan and a production schedule plan that match the condition information 31. Here, the physical information on the 3D CAD is 3D physical information such as piping stored in the 3D CAD DB 26 of the client 3. The physical information on the 3D CAD is transmitted to the line construction unit 14 by the engineering tool unit 25.

A constraint condition, an objective function, an algorithm process, and an output of the line construction unit 14 are described as follows.

### (Constraint Conditions)

Constraint conditions include, for example, the following constraint conditions.
1. Module can be carried in and disposed at a target location
2. Consideration on constraints of a supply chain and logistics
3. Management of availability and schedule of a unit
4. Consideration on utilization efficiency of a physical space
5. Economically reasonable
6. Consideration on whether chemical characteristics of a production unit are tolerable

### (Objective Function)

The objective function includes, for example, the following objective functions.
1. Minimization of energy consumption
2. Maximization of production efficiency and minimization of downtime
3. Minimization of environmental burden in consideration of CO2 emissions
4. Minimization of recombination work and saving of labor
5. Minimization of costs required for line construction

### (Process of Algorithm)

For example, a process of an algorithm is described as follows.
1. Obtain physical dimensions, chemical characteristics, and schedule management information of a module from a database
2. Select an optimum combination from available modules
3. Automatically generate a construction plan of a production line and propose an optimal process flow and arrangement

### (Output)

The output is described as follows.
1. A configuration plan of a selected module
2. A recommended process flow and a production schedule
3. Optimal production line arrangement considering space efficiency, environmental burden, and costs

For example, the condition information 31, the MTP information 32, the physical information 33, the process information 34, the chemical characteristic information 35, the schedule information 36, the reservation management information 37, and the logistics information 38 included in the construction information are used for "2. Select an optimal combination from available modules" and "3. Automatically generate a construction plan of a production line and propose an optimal process flow and arrangement" among the processes of the algorithm.

That is, among the condition information 31, the MTP information 32 of the module, the physical information 33, the process information 34, the chemical characteristic information 35, the schedule information 36, the reservation management information 37, and the logistics information 38 included in the construction information, necessary information is used in the above-described process of the algorithm (1. Obtain physical dimensions, chemical characteristics, and schedule management information of a module from a database, 2. Select an optimal combination from available modules, and 3. Automatically generate a construction plan of a production line and propose an optimal process flow and arrangement).

The condition information 31 is condition information 31 at the time of generating the configuration and arrangement plan of the module of the modular plant. For example, when selecting an optimum combination from the available modules, the line construction unit 14 performs "2. Select an optimal combination from the available modules" of the algorithm, and uses information indicating the configuration of the module of the condition information 31 in the algorithm. Therefore, the construction system A of the embodiment can select the optimum combination of the utilization modules that matches the condition information 31.

In addition, for example, in the case of generating a module arrangement plan, conditions for generating a module arrangement plan of a modular plant are necessary. The line construction unit 14 uses the arrangement plan of the condition information 31 when performing the "3. Automatically generate a construction plan of a production line, and propose an optimal process flow and arrangement" of the algorithm. Therefore, the construction system A according to the embodiment can propose an optimal module arrangement that matches the condition information 31.

In addition, when a production line construction plan is generated, it is necessary to carry in a module into the site. The physical information 33 includes information on a carry-in destination of the module. When a construction plan of a production line is generated, the information on the carry-in destination of the module is required. The line construction unit 14 uses the information on the carry-in destination of the module of the physical information 33 when performing "3. Automatically generate a construction plan of a production line, and propose an optimal process flow and arrangement" of the algorithm. The construction system A of the embodiment can generate a construction plan of a production line suitable for an actual plant by using the physical information 33.

Furthermore, for example, in order to generate an optimal process flow, it is necessary to grasp the process information 34, the chemical characteristic information 35, the schedule information 36, the reservation management information 37, and the logistics information 38 of modules of a plant. For example, the line construction unit 14 can generate a safe process flow by using chemical characteristic information in which non-flammability or the like is defined. Similarly, the construction system A can generate a process flow to be completed within one week by using the schedule information 36 in which one week or the like is defined. By using the reservation management information 37 in which the period of O month O day to × month × day or the like is defined, the construction system A can generate a process flow using modules available within the reservation period. By using the logistics information 38 in which two days or the like is defined as a plant delivery period, the construction system A can generate a process flow in consideration of the plant delivery period.

The line construction unit 14 uses the process information 34, the chemical characteristic information 35, the schedule information 36, the reservation management information 37, and the logistics information 38 when performing "3. Automatically generate a construction plan of a production line, and propose an optimal process flow and arrangement" of the algorithm. The construction system A of the embodiment can propose an optimal process flow suitable for the actual plant by using the production process information 34, the chemical characteristic information 35, the schedule information 36, the reservation management information 37, and the logistics information 38 included in the construction information.

For example, by using the logistics information 38, the line construction unit 14 can know the period from placing an order of the modules of the plant 4 to acquisition on site. The line construction unit 14 can generate a construction plan of a production line that can be quickly started by preferentially selecting a module having a short period from order placement to acquisition on site. The line construction unit 14 can also use the logistics information 38 for a constraint condition and an objective function. For example, when determining "Consideration on constraints of logistics" in the "2. Consideration on constraints of a supply chain and logistics" of the constraint condition, the line construction unit 14 makes a determination by referring to information on the constraints of logistics from market procurement of modules to installation on the site of the plant in the logistics information 38. When determining the "5. Minimization of cost required for line construction" of the objective function, the line construction unit 14 makes a determination by referring to the cost from market procurement of the module to installation of the module on the site of the plant in the logistics information 38.

In addition, the line construction unit 14 can construct a production line having high productivity based on information indicating the maximum carry-out capacity of the module included in the process information 34. In this case, the information indicating the maximum carry-out capacity is used in a process related to the operation efficiency of the objective function and the constraint condition. For example, if there is a production line constructed with modules A, B, and C, and only module B has a very small maximum carry-out capacity, the operation rate of the production line reaches a peak at the maximum carry-out capacity of B. For example, when the constraint condition or the objective function is set to "Maximization of operation efficiency", the line construction unit 14 constructs a production line so that a difference between the maximum carry-out capacities of respective modules does not increase based on the information indicating the maximum carry-out capacity of the modules included in the process information 34. Therefore, the construction system A according to the embodiment does not construct an inefficient production line by using the information indicating the maximum carry-out capacity.

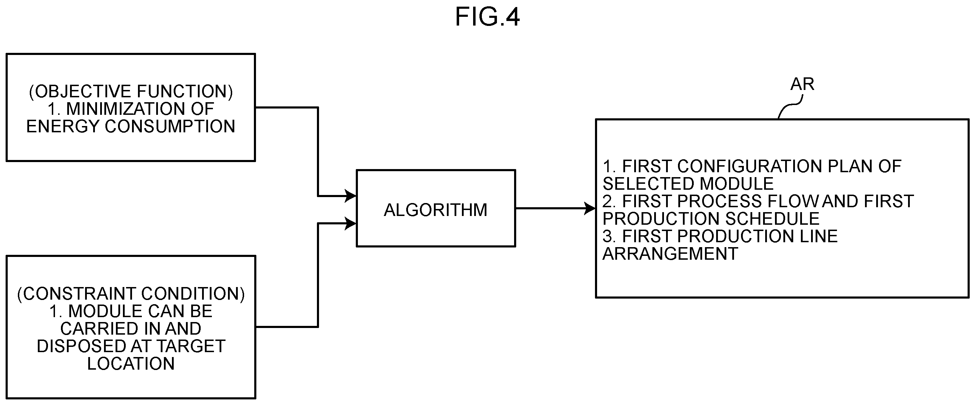

That is, the line construction unit 14 outputs the configuration, the arrangement plan, and the like of the selected module so as to satisfy the constraint condition and satisfy the objective function (condition information). FIG. 4 is a diagram illustrating a first example of a relationship between a constraint condition, an objective function, and an output. As illustrated in FIG. 4, for example, "1. Minimization of energy consumption" as the objective function, and "A module can be carried in and disposed at a target location" as the constraint condition are input to the algorithm AR of the line construction unit 14. Then, the algorithm AR outputs "1. A first configuration plan of a selected module, 2. A first process flow and a first production schedule and 3. First production line arrangement".

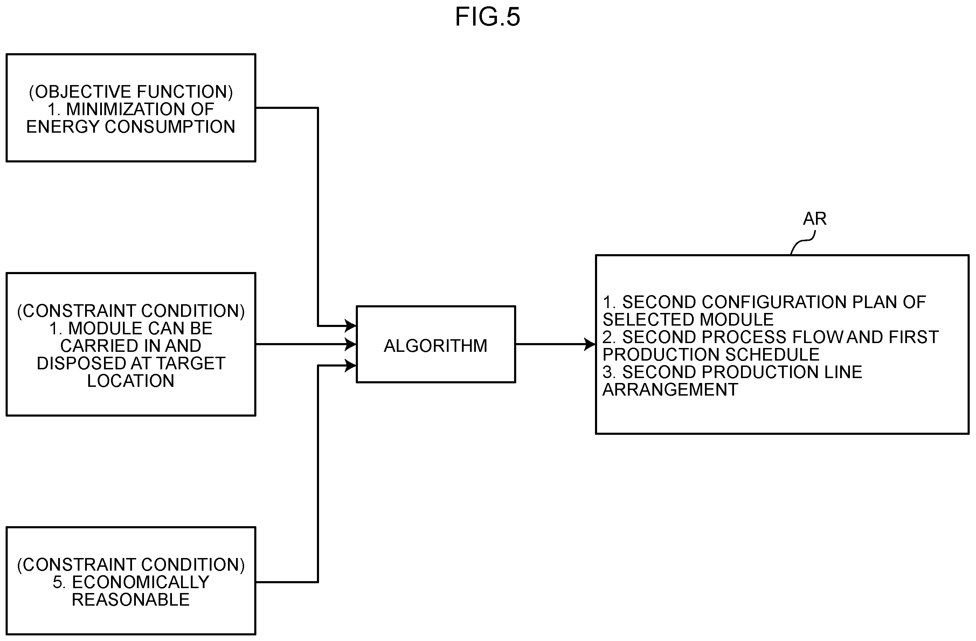

FIG. 5 is a diagram illustrating a second example of the relationship between the constraint condition, the objective function, and the output. As illustrated in FIG. 5, for example, "1. Minimization of energy consumption" as the objective function, and "A module can be carried in and disposed at a target location" and "5. Economically reasonable" as the constraint conditions are input to the algorithm AR of the line construction unit 14. Then, the algorithm AR outputs "1. A configuration plan of a second selected module, 2. A second process flow and a first production schedule, and 3. Second production line arrangement".

That is, the algorithm AR performs different outputs according to the input constraint reception and objective function. It is noted that a plurality of objective functions can also be input.

### (1.2. Client 3)

Referring back to FIG. 2, the description will be given. The client 3 includes the communication control unit 21, the storage unit 22, a control unit 23, and the display unit 24.

### (Communication Control Unit 21)

The communication control unit 21 controls communication with a device outside the client 3. For example, the communication control unit 21 transmits, to the server 2, condition information instructed from a user by the engineering tool unit 25. In addition, the communication control unit 21 receives an arrangement plan, a configuration, and the like of a module transmitted from the server 2, and outputs the arrangement plan, the configuration, and the like to the engineering tool unit 25.

### (Storage Unit 22)

The storage unit 22 is a functional unit that stores various pieces of data. As an example, the storage unit 22 is realized by the internal or auxiliary storage of the client 3. The storage unit 22 stores the 3D CAD DB 26.

The 3D CAD DB 26 stores physical information such as piping of 3D CAD used in combination with the configuration and arrangement plan of the module displayed by the engineering tool unit 25. The physical information such as the piping of the 3D CAD is used when the configuration and arrangement plan of the module are 3D displayed by the engineering tool unit 25.

### (Control Unit 23)

The control unit 23 is a functional unit that performs overall control of the client 3. For example, the control unit 23 can be realized by a hardware processor. The control unit 23 includes the engineering tool unit 25.

The engineering tool unit 25 is a functional unit to be used when designing a modular plant. For example, the engineering tool unit 25 transmits condition information input from the user to the server 2, and receives a configuration, an arrangement plan, and the like of a module, which are generated in the server 2. Then, the engineering tool unit 25 displays the received configuration, arrangement plan, and the like of the module on the display unit 24 by 3D CAD or the like.

### (Display Unit 24)

The display unit 24 is a functional unit that displays various types of information. As an example, the display unit 24 can be realized by a liquid crystal display, an organic electro luminescence (EL) display, or the like. The configuration, arrangement, and the like of the module generated by the engineering tool unit 25 are displayed on the display unit 24.

### (1.3. Plant 4)

The plant 4 is a modular plant that is newly designed or modified. The plant 4 is a manufacturing plant used in fields such as chemistry, medicine, food processing, and electronic component manufacturing. The construction system A can greatly improve process flexibility, extensibility, and customizability in manufacturing processes in these fields.

### (1.4. Data Transfer Relationship)

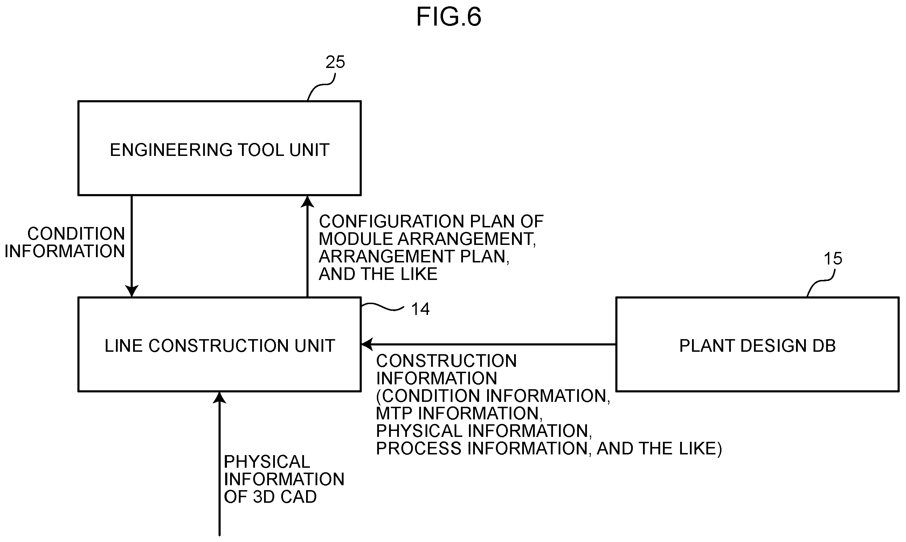

FIG. 6 is a diagram illustrating data transfer among the engineering tool unit 25, the line construction unit 14, and the plant design DB 15.

As illustrated in FIG. 6, the condition information 31 input by the engineering tool unit 25 is sent to the line construction unit 14. It is noted that the condition information sent to the line construction unit 14 is stored in the plant design DB 15 as construction information.

The physical information of 3D CAD stored in the 3D CAD DB 26 is transmitted from the client 3 to the line construction unit 14. In addition, necessary construction information (the condition information 31, the MTP information 32, the physical information 33, the process information 34, the chemical characteristic information 35, the schedule information 36, the reservation management information 37, and the logistics information 38) stored in the plant design DB 15 is transmitted to the line construction unit 14.

The line construction unit 14 generates a configuration plan and an arrangement plan of the module based on the construction information and the physical information on the 3D CAD, and sends the generated configuration plan and arrangement plan of the module to the engineering tool unit 25. The engineering tool unit 25 displays, on the display unit 24, the configuration plan, the arrangement plan, and the like of the module arrangement, which are output from the line construction unit 14.

### (2. Action)

Next, an operation of the construction system A in the modular plant according to the embodiment will be described.

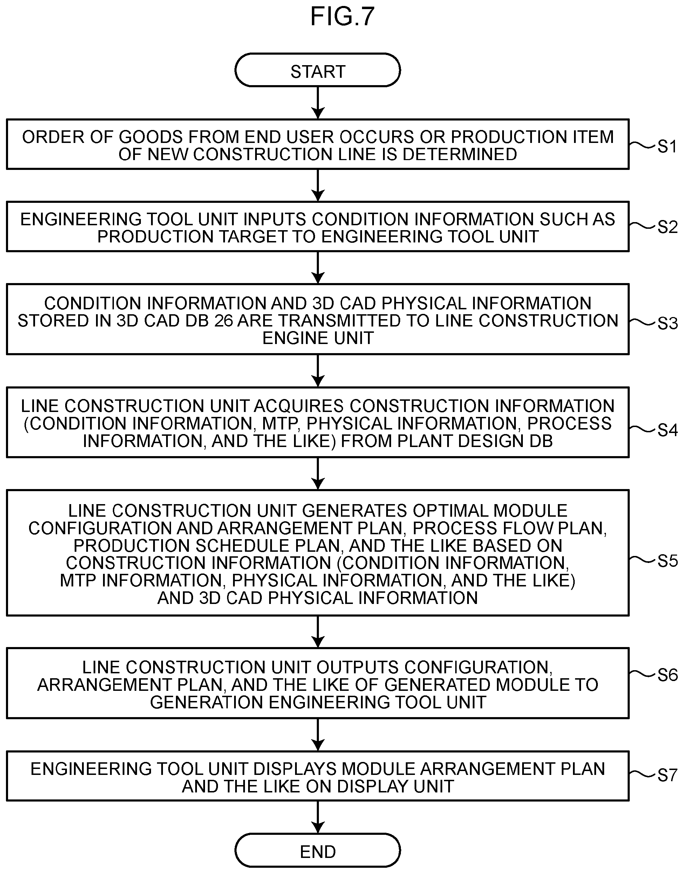

FIG. 7 is a flowchart for describing the operation of the construction system A in the modular plant according to the embodiment. An order for a product from an end user occurs or a production item of a new construction line is determined (step S1). Next, when starting a new project or changing a production line, a designer of the modular plant, who is a user, inputs the condition information 31 such as a production target using the engineering tool unit 25 (step S2).

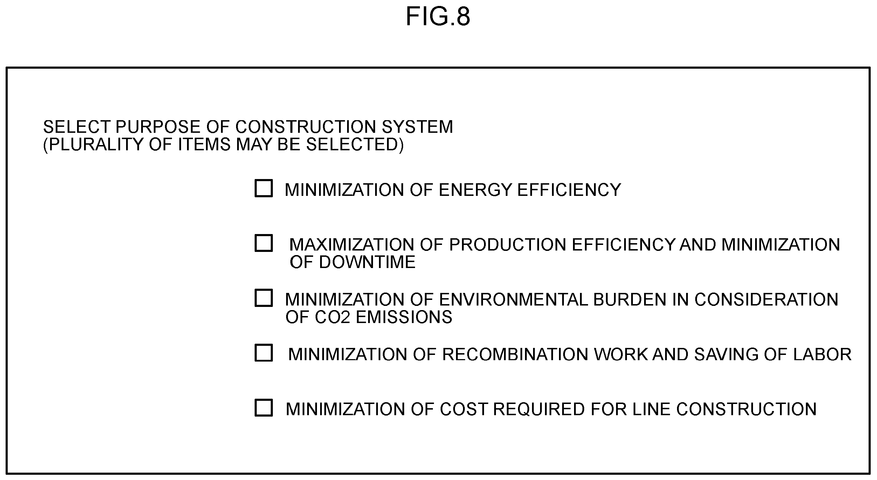

FIG. 8 is a diagram illustrating an example of a screen for inputting condition information of the construction system A in the modular plant according to the embodiment. As illustrated in FIG. 8, a user of the construction system A selects the purpose of a production line to be constructed.

In the example of FIG 8, at least one of the target items is selected from among: 1. Minimization of energy efficiency, 2. Maximization of production efficiency and minimization of downtime, 3. Minimization of environmental burden in consideration of CO2 emissions, 4. Minimization of recombination work and saving of labor, and 5. Minimization of cost required for line construction.

Referring back to FIG. 7, the description will be given. The condition information 31 input to the engineering tool unit 25 and the physical information on the 3D CAD, which is stored in the 3D CAD DB 26, are transmitted to the line construction unit 14 (step S3).

The line construction unit 14 acquires construction information (the condition information 31, the MTP information 32, the physical information 33, the process information 34, and the like) from the plant design DB 15 (step S4).

It is noted that the order of steps S2 to S4 may be different. In addition, the line construction unit 14 may acquire necessary construction information from the plant design DB 15 in advance before the condition information 31 is input.

Next, the line construction unit 14 generates an optimal module configuration and arrangement plan, a process flow plan, a production schedule plan, and the like on the basis of the construction information (the condition information 31, the MTP information 32, the physical information 33, and the like) and the physical information on the 3D CAD (step S5).

Next, the line construction unit 14 outputs the generated configuration, arrangement plan, and the like of the module to the engineering tool unit 25 (step S6). The engineering tool unit 25 displays the module arrangement plan, and the like generated by the line construction unit 14 on the display unit 24 (step S7), and ends the processing.

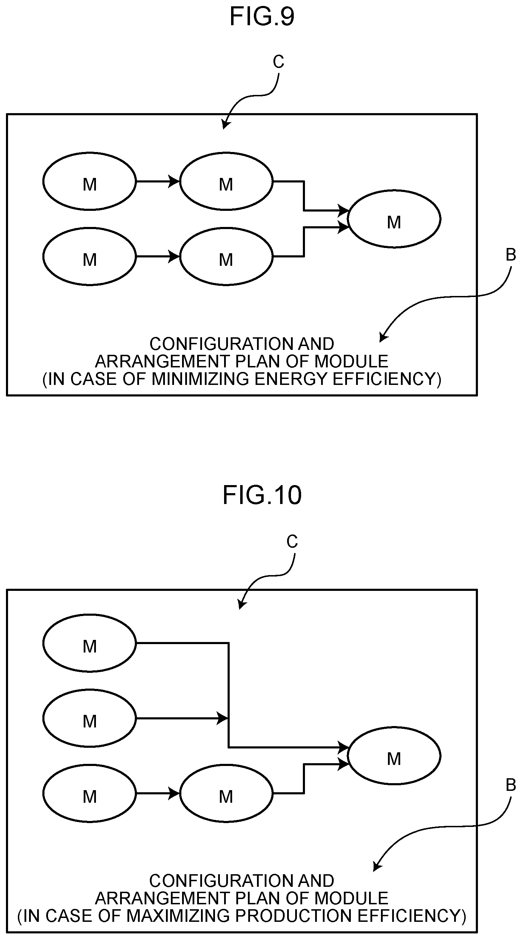

FIG. 9 is a diagram illustrating an example of a configuration and an arrangement plan of a module in the case of minimizing energy efficiency of the construction system A in the modular plant according to the embodiment. As illustrated in FIG. 9, in the configuration and arrangement plan of the module, it is clearly indicated (B) that "In the case of minimizing energy efficiency" together with the configuration and the arrangement plan C of the module. FIG. 10 is a diagram illustrating an example of a configuration and an arrangement plan of a module in the case of maximizing production efficiency of the construction system A in the modular plant according to the embodiment. As illustrated in FIG. 10, in the configuration and arrangement plan of the module, it is clearly indicated (B) that "In the case of maximizing production efficiency" together with the configuration and arrangement plan of the module. In this way, by clearly displaying a configuration and an arrangement of a module, which are generated depending on the purpose, a user can confirm the configuration and arrangement of the module according to the purpose.

### (3. Effects)

As described above, since the production line construction system using the conventional MTP technology constructs the production line system using the MTP information, there are the following problems, and the construction system A according to the embodiment can solve these problems.

First, in the conventional production line construction system, it is difficult to determine whether a designed production line is suitable for an actual plant space, whether there is sufficient space for arrangement of a device, whether necessary wiring or pipelines can be installed, and the like. That is, in the conventional production line, consideration for an actual plant is insufficient.

In addition, the conventional production line construction system focuses on determining an optimum arrangement when a module is newly installed, but rearrangement and expansion of a module in an existing plant are not sufficiently considered. This is a major problem for modem manufacturing industries that need to respond quickly to market demand fluctuations and process updates. That is, in the conventional MTP technology and plant design, consideration for rearrangement of modules is not sufficient.

In addition, the reason for adopting the conventional MTP technology is to improve compatibility between process modules of different manufacturers and flexibility of plant design, but the conventional MTP technology has many restrictions in actual operation while achieving these objects.

The construction system A according to the embodiment is a system capable of modularizing a process from production to packaging of a product by particularly utilizing the MTP technology and easily rearranging these modules. The construction system A also uses the physical information 33 and the chemical characteristics of the module, which are not stored in the MTP file, and the process information 34 such as the maximum carry-out capacity to generate a physical configuration and an arrangement plan of the module, which cannot be realized only by the conventional MTP file. In this way, the construction system A can perform optimization of physical arrangement of modules of a manufacturing line and process design based on chemical characteristics. Therefore, the construction system A can achieve maximization of production efficiency, and can quickly and efficiently change and expand the production line. That is, the construction system A can achieve an advanced design.

The construction system A greatly improves the flexibility of plant design and operation by integrating pieces of data from an external information source. In particular, the construction system A can respond quickly to changing market demand and evolution of production technology. That is, the construction system A can improve flexibility and adaptability.

The construction system A can optimize the operation rate of the production line and minimize the downtime by integrating the schedule information 36 and the reservation management information 37. Accordingly, it is possible to improve overall plant operational efficiency. That is, the construction system A can improve the overall plant operation efficiency.

As described above, the construction system A integrally manages the physical information 33, the chemical characteristics, and the information necessary for unit management in addition to the basic information of the MTP file. Then, an optimal production line is constructed and proposed on the basis of the integrally-managed information. As a result, the construction system A can open up new possibilities of design and operation of the modular plant.

In addition, the construction system A determines whether a logically constructed production line can be suitable for a physical section of an actual plant by separately adding the process information 34 and the physical information 33 and determining the constraint information. Furthermore, the construction system A can propose an optimal configuration and arrangement of units to achieve the shortest pipeline design by 3D CAD or the like.

In addition, the construction system A can be applied to all manufacturing processes from the processing of a raw material to the packaging of a final product. The construction system A also has flexibility applicable to auxiliary processes such as quality control and waste processing.

Furthermore, the construction system A can be applied to production of various products such as synthesis of chemicals, production of pharmaceuticals, processing of foods, and assembly of electronic components. The construction system A can also be applied to environmental technologies and recycling processes, and contributes to construction of a sustainable manufacturing process.

Furthermore, in the construction system A, the line construction unit 14 combines the functional information of the module (the MTP information 32 of the MTP file) with the physical information 33 of the module, which is stored in the plant design DB 15, and the physical information of the 3D CAD, which is stored in the 3D CAD DB 26, thereby providing an arrangement plan in which the module can be functionally and physically moved.

The construction system A of the embodiment can improve productivity and secure flexibility in the manufacturing industry as an alternative to the conventional fixed manufacturing line. In particular, the construction system A of the modular plant provides a great advantage in the modem manufacturing industry where product change and small-lot production are required in a short period of time.

In addition, when the server 2 of the construction system A of the embodiment is used as SaaS, the server 2 can output an optimal production line arrangement in consideration of a configuration plan of a module selected by another user and a user having a plurality of plants, a recommended process flow and production schedule, space efficiency, environmental burden, and cost.

Therefore, when the server 2 of the construction system A of the embodiment is used as SaaS, the user having a plurality of plants can move the stock of a plant B and complete the construction of the production line of a plant A in a case where the construction of the production line cannot be completed only with the stock of the plant A.

### (4. Hardware)

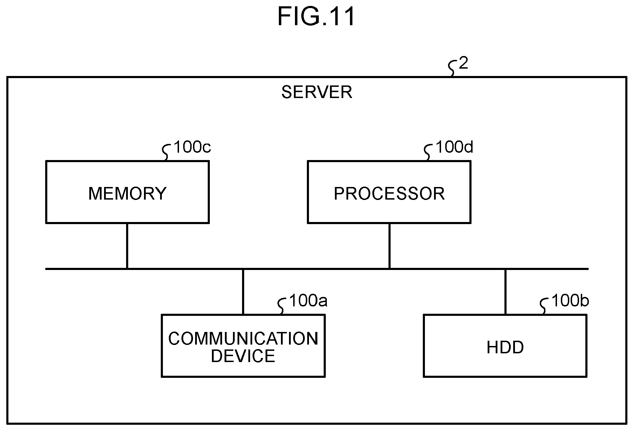

Next, an example of a hardware configuration of the server 2 will be described. FIG. 11 is a diagram for describing a hardware configuration example.

As illustrated in FIG. 11, the server 2 includes a communication device 100a, an HDD 100b, a memory 100c, and a processor 100d. Further, the units illustrated in FIG. 11 are connected to each other by a bus or the like.

The communication device 100a is a network interface card or the like, and communicates with an external device or apparatus. The HDD 100b stores programs and data for operating the functions illustrated in FIG. 7.

The processor 100d reads a program for executing processing similar to that of each processing unit of the server 2 illustrated in FIG. 2 from the HDD 100b or the like and loads the program in the memory 100c, thereby operating a process for executing each function described with reference to FIG. 2 and the like. For example, this process executes a function similar to that of each processing unit included in the server 2. Specifically, the processor 100d reads, from the HDD 100b or the like, a program having a function similar to that of the line construction unit 14. Then, the processor 100d executes a process of executing processing similar to that of the line construction unit 14.

In this manner, the server 2 operates as an information processing device that executes an information processing method by reading and executing a program. In addition, the server 2 can implement functions similar to those of the above-described embodiments by reading a program from a recording medium by a medium reading device and executing the read program. It is noted that the program referred to in this other embodiment is not limited to being executed by the server 2. For example, the present invention can be similarly applied to a case in which another computer or server executes a program or a case in which the other computer and the server execute a program in cooperation.

This program can be distributed via a network such as the Internet. In addition, this program is recorded on a computer-readable recording medium such as a hard disk, a flexible disk (FD), a CD-ROM, a magneto-optical disk (MO), or a digital versatile disc (DVD), and can be executed by being read from the recording medium by the computer.

It is noted that the hardware configuration of the client 3 is similar to the hardware configuration of the server 2 in FIG. 11, except that the hardware configuration of the display unit 24 is omitted.

In this case, the processor 100d reads a program for executing processing similar to that of each processing unit of the client 3 illustrated in FIG. 2 from the HDD 100b or the like and loads the program in the memory 100c, thereby operating a process for executing each function described with reference to FIG. 2 and the like. For example, this process executes a function similar to that of each processing unit included in the client 3. Specifically, the processor 100d reads, from the HDD 100b or the like, a program having a function similar to that of the engineering tool unit 25. Then, the processor 100d executes a process of executing processing similar to that of the engineering tool unit 25.

Some examples of combinations of the disclosed technical features will be described below.
(1) A device for constructing a production line comprising:
   an acquisition unit configured to acquire construction information including definition information and physical information, the definition information defining a function, performance, and interface requirements of a module in a modular plant, the physical information including physical characteristics of the module and information on a carry-in destination of the module; and
   a generation unit configured to generate, based on the acquired construction information, a configuration and an arrangement plan of the module.
(2) The device according to (1), wherein
   the construction information includes condition information at the time of generating a configuration and an arrangement plan of the modular plant, and
   the generation unit generates the configuration and the arrangement plan of the module so as to satisfy the condition information.
(3) The device according to (1) or (2), wherein
   the construction information includes at least one of process information on the modular plant, chemical characteristic information on the module, schedule information indicating a production schedule for the module, reservation management information on the module, or logistics information on the module, and
   the generation unit generates the configuration and the arrangement plan of the module according to a type of the construction information.
(4) The device according to (2), wherein
   the generation unit includes
   generating, based on the acquired construction information, a process flow plan and a production schedule plan each matching the acquired condition information.
(5) The device according to any one of (1)-(4) comprising
   a display unit configured to display the generated configuration and arrangement plan of the module.
(6) The device according to (5), wherein
   the display unit displays the configuration and the arrangement plan of the module through a 3D computer aided design (CAD).
(7) The device according to any one of (1)-(6), wherein
   the physical information includes
   at least one of throughput, capacity, resource and material efficiency, energy efficiency, power consumption, time to service provision, operation time, device availability, mean time between failures, or service and device utilization of the module.
(8) The device according to (1)-(7), wherein
   the generation unit
   generates the configuration and the arrangement plan of the module suitable for a physical space of an actual plant.
(9) The device according to any one of (1)-(8), wherein
   the generation unit generates, based on physical information of a 3D computer aided design (CAD) of the plant, the configuration and the arrangement plan of the module.
(10) A method for constructing a production line comprising:
   acquiring, by a computer, construction information including definition information defining a function, performance, and interface requirements of a module in a modular plant, and physical information including physical characteristics of the module and information on a carry-in destination of the module; and
   generating, by the computer, a configuration and an arrangement plan of the module based on the acquired construction information.
(11) A program for constructing a production line causing a computer to execute processing of:
   acquiring construction information including definition information defining a function, performance, and interface requirements of a module in a modular plant, and physical information including physical characteristics of the module and information on a carry-in destination of the module; and
   generating, based on the acquired construction information, a configuration and an arrangement plan of the module.

A device for constructing a production line in a modular plant of the present disclosure can provide a configuration and an arrangement plan of a module suitable for an actual plant.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A device (A) for constructing a production line comprising:
an acquisition unit (14) configured to acquire construction information (15) including definition information (32) and physical information (33), the definition information (32) defining a function, performance, and interface requirements of a module (M) in a modular plant, the physical information (33) including physical characteristics of the module (M) and information on a carry-in destination of the module (M); and
a generation unit (14) configured to generate, based on the construction information (15), a configuration and an arrangement plan of the module (M).

2. The device according to claim 1, wherein
the construction information (15) includes condition information (31) at the time of generating a configuration and an arrangement plan of the modular plant, and
the generation unit (14) generates the configuration and the arrangement plan of the module (M) so as to satisfy the condition information (31).

3. The device according to claim 1 or 2, wherein
the construction information (15) includes at least one of process information (34) on the modular plant, chemical characteristic information (35) on the module (M), schedule information (36) indicating a production schedule for the module (M), reservation management information (37) on the module (M), and logistics information (38) on the module (M), and
the generation unit (14) generates the configuration and the arrangement plan of the module (M) according to a type of the construction information (15).

4. The device according to claim 2, wherein
the generation unit (14) includes
generating, based on the acquired construction information (15), a process flow plan and a production schedule plan each matching the acquired condition information (31).

5. The device according to any one of claims 1-4, comprising
a display unit (24) configured to display the generated configuration and arrangement plan of the module (M).

6. The device according to claim 5, wherein
the display unit (24) displays the configuration and the arrangement plan of the module (M) through a 3D computer aided design (CAD).

7. The device according to any one of claims 1 to 6, wherein
the physical information (33) includes
at least one of throughput, capacity, resource and material efficiency, energy efficiency, power consumption, time to service provision, operation time, device availability, mean time between failures, and service or device utilization of the module (M).

8. The device according to any one of claims 1 to 7, wherein
the generation unit (14)
generates the configuration and the arrangement plan of the module (M) suitable for a physical space of an actual plant.

9. The device according to any one of claims 1 to 8, wherein
the generation unit (14) generates, based on physical information of a 3D computer aided design (CAD) of the plant, the configuration and the arrangement plan of the module (M).

10. A method for constructing a production line carried out by a computer (A), comprising:
acquiring construction information including definition information defining a function, performance, and interface requirements of a module in a modular plant, and physical information including physical characteristics of the module and information on a carry-in destination of the module; and
generating a configuration and an arrangement plan of the module based on the acquired construction information.

11. A program for constructing a production line that causes a computer to execute a process comprising:
acquiring construction information including definition information defining a function, performance, and interface requirements of a module in a modular plant, and physical information including physical characteristics of the module and information on a carry-in destination of the module; and
generating, based on the acquired construction information, a configuration and an arrangement plan of the module.
